# EUROPEAN PATENT SPECIFICATION

(11) **EP 2 034 536 B1**
(45) Date of publication and mention of the grant of the patent: **17.11.2010**
(21) Application number: 07425555.5
(22) Date of filing: 07.09.2007
(51) Int. Cl.: H01L 45/00

(54) **Phase change memory device for multibit storage**
Phasenwechsel-Speichervorrichtung für Multibit-Speicherung
Dispositif de mémoire à changement de phase pour stockage multibit

(43) Date of publication of application: 11.03.2009
(73) Proprietor: STMicroelectronics Srl, 20041 Agrate Brianza (MB) (IT); Politecnico di Milano, 20133 Milano (IT)
(72) Inventor: Redaelli, Andrea, 23900 Lecco (IT); Pellizzer, Fabio, 20040 Cornate D'Adda (IT); Pirovano, Agostino, 20011 Corbetta (IT)
(74) Representative: Bartle, Robin Jonathan

(56) References cited:
- EP-A- 1 764 847
- WO-A-94/24707
- US-A1- 2004 195 604
- US-A1- 2005 139 816
- US-A1- 2006 249 725
- TYSON S ET AL: "Nonvolatile, high density, high performance phase-change memory" AEROSPACE CONFERENCE PROCEEDINGS, 2000 IEEE MARCH 18-25, 2000, PISCATAWAY, NJ, USA,IEEE, vol. 5, 18 March 2000 (2000-03-18), pages 385-390, XP010517190 ISBN: 0-7803-5846-5

## Description

The present invention relates to a phase change memory device for multibit storage.

As is known, phase change memory devices use phase change materials, i.e., materials that may be electrically switched between a generally amorphous and a generally crystalline state or between different detectable states of local order across the entire spectrum between completely amorphous and completely crystalline states, for electronic memory application. The state of the phase change materials is also non-volatile in that, when set in either a crystalline, semi-crystalline, amorphous, or semi-amorphous state representing a resistance value, that value is retained until changed by another programming event, as that value represents a phase or physical state of the material (e.g., crystalline or amorphous). The state is unaffected by removing electrical power.

At present, alloys of group VI of the periodic table, such as Te or Se, referred to as chalcogenides or chalcogenic materials, can advantageously be used in phase change cells as phase change materials. The most promising chalcogenide is formed by a Ge, Sb and Te alloy (Ge₂Sb₂Te₅), also called GST, which is currently widely used for storing information in overwritable disks.

In chalcogenides, the resistivity varies by two or more magnitude orders when the material passes from the amorphous phase (more resistive) to the polycrystalline phase (more conductive) and vice versa.

Phase change may be obtained by locally increasing the temperature. Below 150°C all phases are stable. Above 200°C (temperature of start of nucleation), fast nucleation of the crystallites takes place, and, if the material is kept at the crystallization temperature for a sufficient length of time, it changes its phase and becomes crystalline (so-called set state). To bring the chalcogenide back into the amorphous state (reset state), it is necessary to raise the temperature above the melting temperature (approximately 600°C) and then to cool the chalcogenide off rapidly. Intermediate phases may be obtained applying suitable temperatures for different times, which cause the formation of amorphous "spots" or "bubbles" of different dimensions in contact with the heater.

From the electrical standpoint, it is possible to cause the chalcogenic material to change state by causing a current to flow through a resistive element, called a heater, which heats the chalcogenic material by the Joule effect.

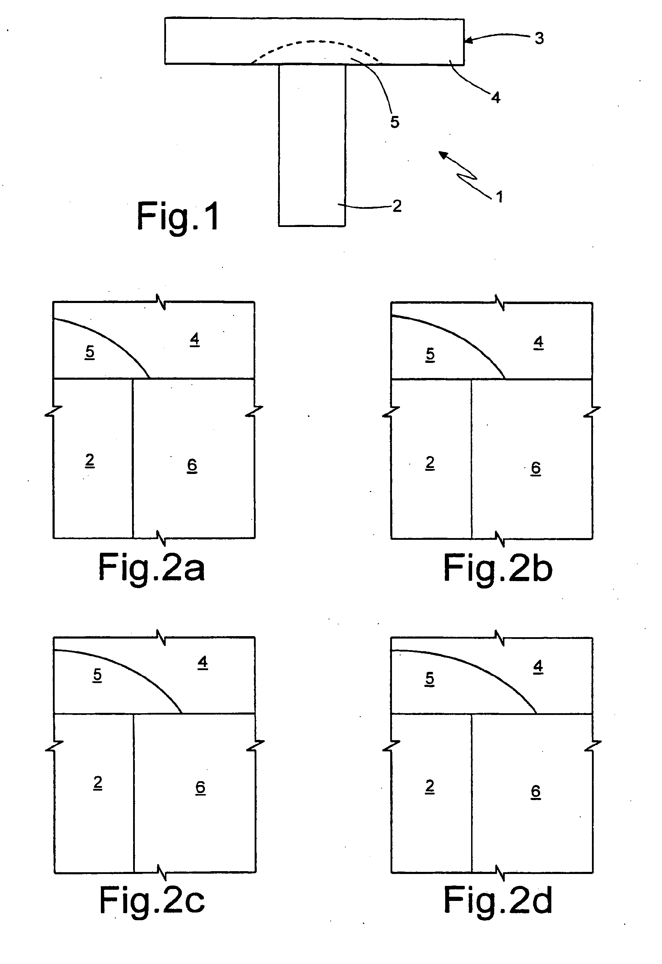

The basic structure of a PCM element 1 which operates according to the principles described above is shown in Figure 1 and comprises a heater element 2 and a memory element 3 of chalcogenic material. A portion of the memory element 3 (generally polycrystalline) is in direct contact with the heater 2 and is subject to phase change between amorphous and polycrystalline. Figure 1 shows a PCM element in an intermediate state, wherein the portion that has not changed phase and enables a good flow of current is referred to as polycrystalline portion 4 and the portion that has changed state is referred to as amorphous portion 5. The dimensions of the amorphous portion 5 define the overall resistivity of the memory region 3 and thus of the PCM element 1. Thus, different resistance levels may be associated with different bits and may be obtained by generating appropriate program currents that cause the amorphous portion 5 to assume different dimensions.

A critical issue in the multilevel programming resides in the discrimination among the different programmed states within a reasonable time.

For a better understanding of this problem, reference is made to Figures 2a-2d, showing a portion of the PCM element 1 of Figure 1 in different programming conditions, obtained using progressively higher programming currents. In Figures 2a-2d, the same reference numbers have been used as in Figure 1, while number 6 represents a dielectric layer surrounding the heater 2.

As visible in Figures 2a-2d, the amorphous portions 5 have different dimensions (radiuses). In detail, in Figure 2a, where a lower programming current was used (e.g., ip = 1.32 mA), the phase change portion 5 extends just a little beyond the edge of the heater 2, while in Figures 2b, 2c, 2d (obtained e.g. using programming currents ip = 1.42 mA, 1.51 mA and 1.6 mA, respectively) the protruding portion of the phase change portion 5 is gradually bigger.

Although the dimensions of amorphous portions 5 are quite different in the four Figures, the difference in the resistance of the PCM element 1 in Figures 2a-2d does not change to the same extent. In fact, the current path from the heater 2 to the polycrystalline portion 4 passes through the high resistive amorphous portion 5; therefore the current path resistance is very high in all four conditions. Thus, the difference in resistance among the four conditions is small, compared with its absolute value, and the discrimination among the different states may be problematic, or the reading time may be unacceptably increased.

On the other hand, if a thin amorphous portion or a plurality of nanoportions are used, to obtain lower resistance values, the amorphous portion or portions is/are less stable in temperature and more subject to a resistance drift that causes reading errors.

Moreover, the programmed resistance is entirely associated to the high resistivity of the amorphized portion. It follows that the time-dependent resistivity variation usually observed for the amorphous portion directly affects the resistance of the cell, thus impacting the reading capability of intermediate levels.

In other words, ease and speed in reading are difficult to obtain without impairing stability in temperature and time.

The aim of the invention is thus to provide a phase change memory device having an improved behavior.

According to the present invention, there are provided a phase change memory device and a fabrication method thereof, as defined respectively in claims 1 and 13.

For the understanding of the present invention, preferred embodiments thereof are now described, purely as non-limitative examples, with reference to the enclosed drawings, wherein:
- Figure 1 shows the basic structure of a known phase change memory element;
- Figures 2a-2d show a portion of the phase change memory element of Figure 1 in different programming conditions;
- Figures 3a-3d show a portion of a phase change memory element according to a schematical representation of the present phase change memory device in different programming conditions;
- Figure 4 shows a representation of the current vs. voltage plot for the phase change memory element according to Figure 3a-3d;
- Figure 5 shows a cross-section of a phase change memory element according to an embodiment of the invention;
- Figure 6 shows a cross-section of a phase change memory element according to another embodiment of the invention; and
- Figure 7 is a system depiction for another embodiment of the invention.

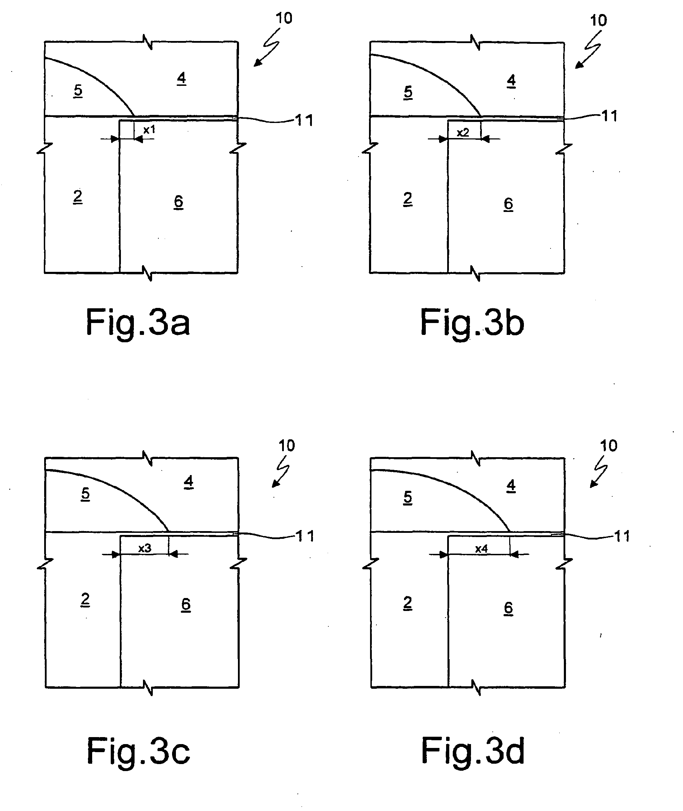

Figures 3a-3d show a portion of a PCM element 10 including a heater 2 surrounded by a dielectric layer 6 and overlaid by a memory element 3, analogously to the PCM element 1 of Figures 1, 2a-2d. In Figures 3a-3d, the memory element 3 has been programmed in four different conditions and includes a polycrystalline portion 4 and an amorphous portion 5, analogously to Figures 1, 2a-2d. Here, a thin resistive region 11 protrudes from the top edge of the heater 2 along the interface between the dielectric layer 6 and the memory element 3. The thin resistive region 11 is of a conductive material, e.g. metal or doped polysilicon, and has a reduced thickness. Preferably, the thin resistive region 11 is of the same material as the heater 2, for example TiN, TiAlN, TiSiN. In the alternative, it may be of a different material. For example, the heater 2 may be of TiAlN and the thin resistive region 11 is of TiSiN, or vice versa. However, other resistive materials may be used and, in general, the thin resistive region 11 may have the same, a higher or a lower resistivity than the heater 2, according to the desired resistivity and resistance differences for the various programmed states.

Furthermore, the thin resistive region 11 has a thickness lower than 10 nm, for example comprised between 1 and 10 nm, preferably about 5 nm.

The thin resistive region 11 forms a parallel path for a reading current flowing between the heater 2 and the polycrystalline portion 4 of the memory element 3 and its resistance depends on the dimensions of the amorphous portion 5. In fact, a first part of the reading current flowing between the heater 2 and the polycrystalline portion 4 flows through the amorphous portion 5 and a second part thereof flows through the thin resistive region 11. In particular, the second part of the current flows across a length of the thin resistive region 11 which is equal to the distance between the edge of the heater 2 and the edge of the amorphous portion 5. Since such a length depends on the programmed state of the PCM element 1, the parallel path has a resistance whose value depends on the programmed state of the PCM element 1. Furthermore, since the resistance of the parallel path (for a positive length of the parallel path) is much lower than the resistance of the amorphous portion, the overall resistance of the PCM element 1 depends mainly on the parallel path. Since the resistance of the parallel path depends linearly on the length thereof, the difference in resistance among the various programmed states is easily detectable by the reading circuit.

The above is clear from the comparative observation of Figures 3a-3d, wherein the amorphous portion 5 has different dimensions according to four different programming conditions of the PCM element 10, namely obtained using progressively higher programming currents, analogously to Figures 2a-2d.

In detail, in Figure 3a, where a lower programming current was used (e.g., ip = 1.32 mA), the phase change portion 5 extends just a little beyond the edge of the heater 2. The length X1 of the protruding portion is also the length of the parallel path.

In Figures 3b, 3c and 3d (obtained e.g. using programming currents ip = 1.42 mA, 1.51 mA and 1.6 mA, respectively) the protruding portion of the phase change portion 5 is gradually longer. In those Figures, the lengths of the protruding portions are indicated by X2, X3 and X4. For example, assuming that X2 = 2*X1, the resistance R2 of the parallel path in Figure 3b is almost double than the resistance R1 in Figure 3a (R2 ≈ 2*R1). Analogously, assuming that X3 = 3*X1 and X4 = 4*X1, the respective resistances are R3 ≈ 3*R1 and R4 ≈ 4*R1.

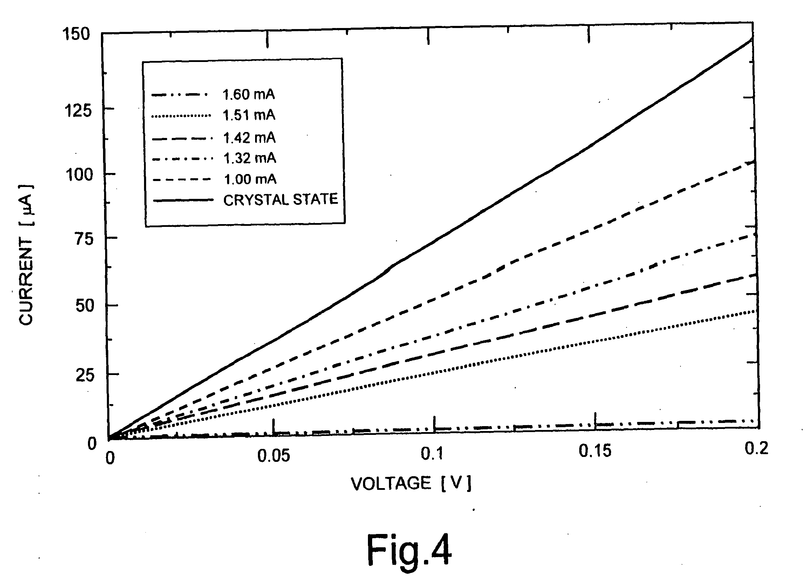

The resistance of the PCM element 10 as a function of the programming current (and thus the dimension of the amorphous portion 5) is plotted in Figure 4, showing the current versus voltage plot in seven different conditions, from a completely crystalline memory element 3 (curve with continuous line) to the completely resetted memory element 3 (abscissa line). From Figure 4 it is clear that, if the PCM element 10 is read at a reading voltage of 0,2 V, very different current values are obtained, which can be discriminated very easily and rapidly by a reading stage.

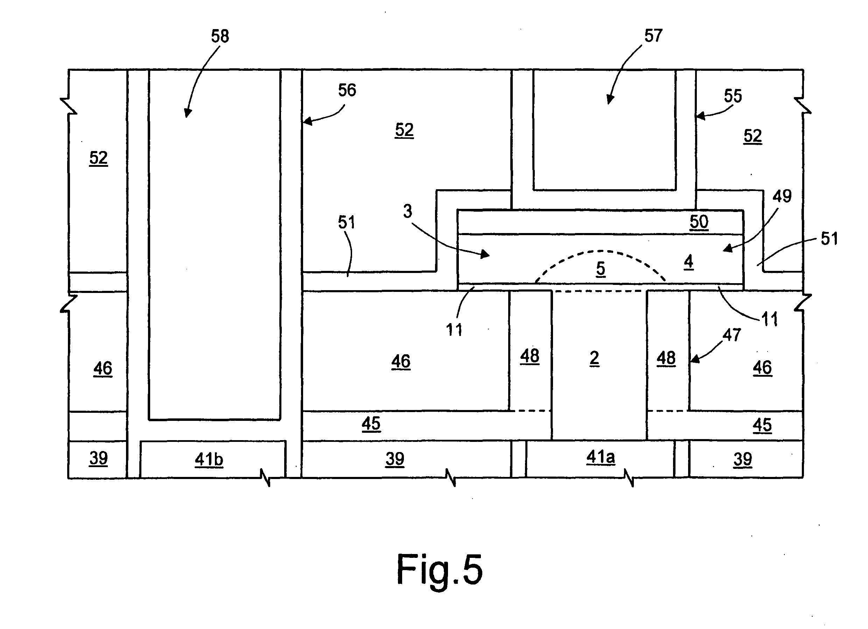

Figure 5 shows an implementation of the structure of Figures 3a-3d in a phase change memory cell of the lance type, as described for example in EP-A-1 675 183, wherein the thin resistive region 11 has been introduced.

In detail, Figure 5 shows a phase change memory cell including a first dielectric layer 39 (preferably, USG -Undoped Silicate Glass-) extending on a semiconductor substrate which is not shown and accommodates access or selector elements, in a per se known manner. First-level plugs or contacts 41a and 41b extend through the first dielectric layer 39 and comprise, e.g., a barrier layer, e.g. a multiple Ti/TiN layer, and a tungsten filler. First-level plugs 41a and 41b are connected to two terminals of the access element, e.g. the emitter and the base regions of a bipolar junction transistor or the source and gate regions of a MOS transistor, in a per se known manner.

A nitride layer 45 and a second dielectric layer 46 extend on the first dielectric layer 39; an opening 47 extends in the second dielectric layer 46 and in the nitride layer 45 on top of the first-level plug 41a; a spacer 48 of silicon nitride coats the walls of the opening 40 and surrounds the heater 2.

A stack 49 formed by the thin conductive region 11, the chalcogenic region 3 of GST (Ge₂Sb₂Te₅), and a cap region 50, of metal, extends over and in contact with the heater 2. The stack 49 forms a bit line running perpendicularly to the plane of Figure 5 and forming a contact with the heater 2 having a sub-lithographic dimension by virtue of the sub-lithographic width of the heater.

The stack 49 is laterally and upwardly sealed by a sealing layer 51, e.g. of nitride, extending also at the interface between the second dielectric layer 46 and a third dielectric layer 52. A first hole 55 extends through the third dielectric layer 52 and a second hole 56 extends through the second and the third dielectric layers 46, 52. The holes 55, 56 are coated with a barrier layer and filled by a metal layer, e.g. of Cu, to form second-level plugs 57 and 58 which are in contact with the stack 9 and the first-level plug 41b, respectively.

In the cell of Figure 5, the heater may be formed by depositing the nitride layer 45, depositing the second dielectric layer 46, digging an opening in the layers 45 and 46, depositing a spacer layer and removing it from the bottom of the opening, filling the opening with a heating layer and removing the excess heating layer and spacer by CMP ("Chemical Mechanical Polishing"). Then, the stack 49 is formed by depositing, in sequence, a resistive layer, e.g. of TiN, TiAlN, TiSiN, a GST layer and a metal layer, and defining these three layers using a same mask. Thereafter, the sealing layer 51 is deposited.

In the alternative, the heater is cup-shaped and the drawings shows only a vertical wall thereof extending over the first-level plug 41a. In this case, after digging an opening, a spacer layer, a heater layer, a sheath layer and the second dielectric layer are deposited; and the wafer is planarized.

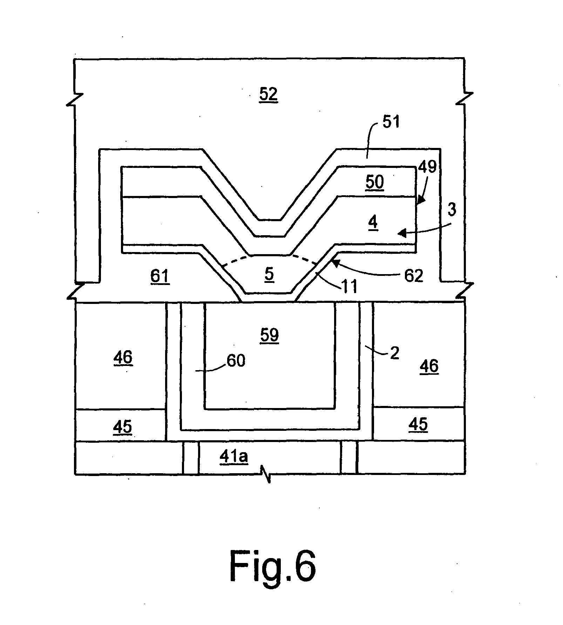

Figure 6 shows an implementation of the structure of Figures 3a-3d in a phase change memory cell of the tapered microtrench type, as described for example in US 2005/0142863, wherein the thin resistive region 11 has been introduced.

In Figure 6, the heater 2 is formed by a cup-shaped region formed in an opening extending in the second dielectric layer 46 and in the nitride layer 45 above and in contact with the first-level plug 41a. The cup-shaped region, from above, has a ring-like or an elongated shape (e.g., rectangular or oval) and is internally surrounded by sealing region 60, e.g. of nitride, and a filling region 59, e.g. of USG.

A mold layer 61, e.g. of nitride, extends over the second dielectric layer 46 and forms a microtrench 62 having inclined walls and tapered profile. The microtrench 62 may be formed by plasma etch using the process described in US 2005/0142863. In particular, the microtrench 62 has a sublithographic bottom width and a lithographic top width.

A stack 49 formed by the thin conductive region 11, the chalcogenic region 3 of GST (Ge₂Sb₂Te₅), and a cap region 50, of metal, extends in part within the microtrench 62 so as to contact the cup-shaped heater 2 in a plane parallel to the drawing sheet. The stack 49 may form a bit line running perpendicularly to the plane of Figure 6 and has a sublithograhic dimension in the horizontal direction. In the alternative, the stack 49 has a dot-like shape, and a bitline of metal contacts the stack 49.

Analogously to figure 5, a further sealing layer 51 surrounds the stack 49.

Here, the chalcogenic region 3 makes a sub-lithographic contact with the heater 2 since the heater 2 has a sub-lithographic thickness in one direction (perpendicular to the drawing plane, at the contact area) and the stack has a sub-lithographic dimension in the horizontal direction of the drawing.

The advantages of the present invention are clear from the above description. In particular, the presence of a parallel current path whose resistance depends upon the dimensions of the amorphous region 5 allows a better control of the programmed resistance. Thus, multilevel storage may be obtained, wherein the various bit stored in a same memory cell are associated with resistance values that can be programmed with high accuracy and easily discriminated. Thus, the sensing is simpler, faster and highly reliable.

Furthermore, the use of a parallel resistive path allows the use of an amorphous region or spot of suitable dimensions, thus improving the resistance stability of the programmed phase with time.

Moreover, since the overall resistance mainly depends on the parallel path resistivity, any modification of the resistivity of the amorphous portion on the cell resistance is negligible.

The solution is very simple and requires only the deposition of an extra layer with respect to standard processes, both in the lance and in the microtrench architectures; thus the invention does not increase the costs for manufacturing the memory cell or for its operation.

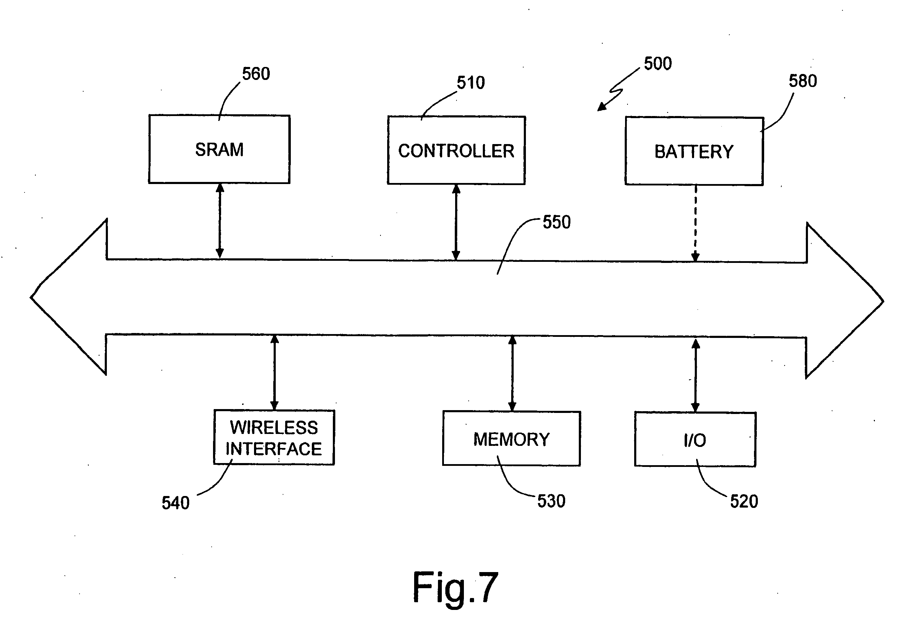

Turning to Figure 7, a portion of a system 500 in accordance with an embodiment of the present invention is described. System 500 may be used in wireless devices such as, for example, a personal digital assistant (PDA), a laptop or portable computer with wireless capability, a web tablet, a wireless telephone, a pager, an instant messaging device, a digital music player, a digital camera, or other devices that may be adapted to transmit and/or receive information wirelessly. System 500 may be used in any of the following systems: a wireless local area network (WLAN) system, a wireless personal area network (WPAN) system, a cellular network, although the scope of the present invention is not limited in this respect.

System 500 includes a controller 510, an input/output (I/O) device 520 (e.g. a keypad, display), static random access memory (SRAM) 560, a memory 530, and a wireless interface 540 coupled to each other via a bus 550. A battery 580 is used in some embodiments. It should be noted that the scope of the present invention is not limited to embodiments having any or all of these components.

Controller 510 comprises, for example, one or more microprocessors, digital signal processors, microcontrollers, or the like. Memory 530 may be used to store messages transmitted to or by system 500. Memory 530 may also optionally be used to store instructions that are executed by controller 510 during the operation of system 500, and may be used to store user data. Memory 530 may be provided by one or more different types of memory. For example, memory 530 may comprise any type of random access memory, a volatile memory, a non-volatile memory such as a flash memory and includes the phase change memory device according to Figures 3a-3d.

I/O device 520 may be used by a user to generate a message. System 500 uses wireless interface 540 to transmit and receive messages to and from a wireless communication network with a radio frequency (RF) signal. Examples of wireless interface 540 may include an antenna or a wireless transceiver, although the scope of the present invention is not limited in this respect.

Finally, it is clear that numerous variations and modifications may be made to the phase change memory cell and process described and illustrated herein, all falling within the scope of the invention as defined in the attached claims. For example, although the thin resistive region 11 is described as being a separate region from the heater 2, formed by an own deposition step, it may be formed by the same material of the heater, by stopping the CMP just before reaching the second dielectric layer so as to form a thin resistive layer that is then patterned by an own etching step or during patterning of the stack 49. In this case, in Figure 5, the thin resistive region 11 may be considered a projecting portion of the heater 2.

## Claims

1. A phase change memory device comprising a heater element (2) and memory region (3) of chalcogenic material, the memory region having a phase changing portion (5) in electrical and thermal contact with said heater element and forming a first current path between the heater element and a rest portion (4) of said memory element, the phase changing portion having a dimension and a different resistivity from the rest portion, said dimension being correlated to information stored in said memory region,
**characterised by** a thin resistive region between said phase change portion (5) and a dielectric (6) to provide a parallel current path (11) between said heater element (2) and said rest portion (4) of said memory element (3).

2. The phase change memory device according to claim 1, wherein said parallel current path (11) has a resistance depending upon said dimension and lower than said phase changing portion (5).

3. The phase change memory device according to claim 1 or 2, wherein said parallel path is a resistive region (11) extending from an upper edge of said heater (2) element, between an insulating region (6; 46, 48; 61) and said memory region (3).

4. The phase change memory device according to claim 3, wherein the resistive region (11) is of a material selected between metal and polysilicon.

5. The phase change memory device according to claim 3 or 4, wherein the resistive region (11) is of a same material as the heater element.

6. The phase change memory device according to claim 3 or 4, wherein the resistive region (11) is of a different material from the heater element (2).

7. The phase change memory device according to any of claims 3 to 6, wherein the resistive region (11) is of a material selected from TiN, TiAlN, TiSiN.

8. The phase change memory device according to any of claims 3 to 6, wherein the resistive region (11) has a thickness lower than 10 nm, preferably comprised between 1 and 10 nm, most preferably of 4-5 nm.

9. The phase change memory device according to any of claims 3-5 or 7, 8, wherein the resistive region (11) is a projecting portion of the heater element (2) in contact with the memory region (3).

10. A phase change memory device according to any of claims 3 to 7, wherein the heater element (2) is a lance element surrounded by said insulating layer (46, 48) and the device comprises a planar memory stack (49) including said resistive region (11) and said memory region (3).

11. A phase change memory device according to any of claims 3 to 7, wherein the insulating region comprises a dielectric layer (46) surrounding the heater element (2) and a mold layer (61) extending over the dielectric layer, the mold layer having a tapered microtrench (62) with has a shallower base towards the heater element (2) and a memory stack (49) extends at least in part in said tapered microtrench and includes said resistive region (11) and said memory region (3).

12. A system comprising:
a processor (510);
a static random access memory (560) coupled to said processor; and
a memory (530) coupled to said processor, the memory comprising the phase change memory device (10) according to any of claims 1-11.

13. A process for manufacturing a phase change memory device comprising forming a heater element (2) and forming a memory region (3) of chalcogenic material in electrical and thermal contact with the heater element, the memory region having a phase changing portion (5) towards the heater element forming a first current path between the heater element and a rest portion (4) of said memory element, the phase changing portion having a dimension and a different resistivity from a rest portion, said dimension being correlated to information stored in said memory region,
**characterised by** forming a thin resistive region between said phase change portion (5) and a dielectric (6) to provide a parallel current path (11) between said heater element (2) and said rest portion (4) of said memory element.

14. The process according to claim 13, wherein forming a parallel current path comprises, before forming said memory region, forming a resistive region (11) over an insulating region (6; 46, 48) surrounding the heater element (2) and extending from an upper edge of said heater element.

15. The process according to claim 14, wherein the phase change portion (5) has a higher resistivity than said rest portion (4) and the resistive region (11) has a lower resistivity than the phase changing portion (5).

16. The process according to claim 14 or 15, wherein the resistive region (11) is of a material selected between metal and polysilicon.

17. The process according to any of claims 14-16, wherein the resistive region (11) is of a same material as the heater element.

18. The process according to any of claims 14 to 17, wherein the resistive region (11) is of a material selected from TiN, TiAlN, TiSiN.

19. The process according to any of claims 14 to 18, wherein the resistive region (11) has a thickness lower than 10 nm, preferably comprised between 1 and 10 nm, most preferably of 4-5 nm.

20. The process according to any of claims 14 to 19, wherein forming the heater element (2) comprises forming the insulating layer (6; 46, 48); forming an opening in the insulating layer; depositing a heater layer (2) in the opening; removing an excess heater layer outside the opening to have a planarized surface; depositing a layer stack (49) including a resistive layer (11) and a chalcogenic layer (3); patterning the layer stack in a same patterning step to form a memory stack (49) including the memory region (3) and the resistive region (11).

21. A process according to any of claims 14 to 20, wherein forming the heater element (2) comprises forming the insulating layer (46); forming an opening in the insulating layer; depositing a heater layer (2) in the opening; removing an excess heater layer outside the opening to have a planarized surface; depositing a mold layer (61) over the planarized surface; forming, in the mold layer, a tapered aperture (62) having a shallower base in contact with the heater element; depositing a layer stack (49) including a resistive layer (11) and a chalcogenic layer (3); patterning the layer stack (49) in a same patterning step to form a memory stack including the memory region (3) and the resistive region (11) having a least one portion in the tapered aperture.

## Patentansprüche

1. Phasenwechsel-Speichervorrichtung, umfassend ein Heizungselement (2) und eine Speicherregion (3) aus Chalkogenmaterial, wobei die Speicherregion einen Phasenwechselabschnitt (5) hat, der in elektrischem und thermischem Kontakt mit dem genannten Heizungselement steht und einen ersten Strompfad zwischen dem Heizungselement und einem Restabschnitt (4) des genannten Speicherelements bildet, wobei der Phasenwechselabschnitt eine Dimension und einen von demjenigen des Restabschnitts verschiedenen spezifischen Widerstand hat, wobei die genannte Dimension zu in der genannten Speicherregion gespeicherten Informationen korreliert ist,
**gekennzeichnet durch** einen parallelen Strompfad (11) zwischen dem genannten Heizungselement (2) und dem genannten Restabschnitt (4) des genannten Speicherelements (3).

2. Phasenwechsel-Speichervorrichtung nach Anspruch 1, wobei der genannte parallele Strompfad (11) einen Widerstand hat, der von der genannten Dimension abhängt und niedriger ist, als derjenige des Phasenwechselabschnitts (5).

3. Phasenwechsel-Speichervorrichtung nach Anspruch 1 oder 2, wobei es sich bei dem genannten parallelen Pfad um eine Widerstandsregion (11) handelt, die sich von einem oberen Rand des genannte Heizungselements (2) zwischen einer isolierenden Region (6; 46, 48; 61) und der genannten Speicherregion (3) erstreckt.

4. Phasenwechsel-Speichervorrichtung nach Anspruch 3, wobei die Widerstandregion (11) aus einem aus Metall und Polysilizium ausgewählten Material besteht.

5. Phasenwechsel-Speichervorrichtung nach Anspruch 3 oder 4, wobei die Widerstandsregion (11) aus einem gleichen Material besteht wie das Heizungselement.

6. Phasenwechsel-Speichervorrichtung nach Anspruch 3 oder 4, wobei die Widerstandsregion (11) aus einem anderen Material besteht als das Heizungselement (2).

7. Phasenwechsel-Speichervorrichtung nach einem der Ansprüche 3 bis 6, wobei die Widerstandregion (11) aus einem aus TiN, TiAlN, TiSiN ausgewählten Material besteht.

8. Phasenwechsel-Speichervorrichtung nach einem der Ansprüche 3 bis 6, wobei die Widerstandsregion (11) eine Dicke von weniger als 10 nm hat, vorzugsweise umfassend zwischen 1 und 10 nm, am besten 4-5 nm.

9. Phasenwechsel-Speichervorrichtung nach einem der Ansprüche 3-5 oder 7,8, wobei es sich bei der Widerstandsregion (11) um einen vorstehenden Abschnitt des Heizungselements (2) handelt, der mit der Speicherregion (3) in Kontakt steht.

10. Phasenwechsel-Speichervorrichtung nach einem der Ansprüche 3 bis 7, wobei es sich bei dem Heizungselement (2) um ein von der genannten Isolierschicht (46, 48) umgebenes Lanzenelement handelt und die Vorrichtung einen ebenen Speicherstapel (49) umfasst, der die genannte Widerstandsregion (11) und die genannte Speicherregion (3) enthält.

11. Phasenwechsel-Speichervorrichtung nach einem der Ansprüche 3 bis 7, wobei die isolierende Region eine das Heizungselement (2) umgebende dielektrische Schicht (46) und eine sich über die dielektrische Schicht erstreckende Formschicht (61) umfasst, wobei die Formschicht einen verjüngten Mikrograben (62) mit einem zum Heizungselement (2) hin flacheren Boden hat und sich ein Speicherstapel (49) mindestens teilweise im genannten verjüngten Mikrograben erstreckt und die genannte Widerstandsregion (11) und die genannte Speicherregion (3) enthält.

12. System, das Folgendes umfasst:
einen Prozessor (510);
einen an den genannten Prozessor gekoppelten statischen Direktzugriffsspeicher (560); und
einen an den genannten Prozessor gekoppelten Speicher (530), wobei der Speicher die Phasenwechsel-Speichervorrichtung (10) nach einem der Ansprüche 1-11 umfasst.

13. Verfahren zum Herstellen einer Phasenwechsel-Speichervorrichtung, umfassend das Bilden eines Heizungselements (2) und das Bilden einer Speicherregion (3) aus Chalkogenmaterial in elektrischem und thermischem Kontakt mit dem Heizungselement, wobei die Speicherregion einen Phasenwechselabschnitt (5) zum Heizungselement hin hat, der einen ersten Strompfad zwischen dem Heizungselement und einem Restabschnitt (4) des genannten Speicherelements bildet, wobei der Phasenwechselabschnitt eine Dimension und einen vom demjenigen des Restabschnitts verschiedenen spezifischen Widerstand hat, wobei die genannte Dimension zu in der genannten Speicherregion gespeicherten Informationen korreliert ist,
**gekennzeichnet durch** Bilden eines parallelen Strompfads (11) zwischen dem genannten Heizungselement (2) und dem genannten Restabschnitt (4) des genannten Speicherelements.

14. Verfahren nach Anspruch 13, wobei das Bilden eines parallelen Strompfads vor dem Bilden der genannten Speicherregion das Bilden einer Widerstandsregion (11) über einer das Heizungselement (2) umgebenden und sich von einem oberen Rand des genannten Heizungselements erstreckenden isolierenden Region (6; 46, 48) umfasst.

15. Verfahren nach Anspruch 14, wobei der Phasenwechselabschnitt (5) einen höheren spezifischen Widerstand hat als der genannte Restabschnitt (4) und die Widerstandsregion (11) einen niedrigeren spezifischen Widerstand hat als der Phasenwechselabschnitt (5).

16. Verfahren nach Anspruch 14 oder 15, wobei die Widerstandregion (11) aus einem aus Metall und Polysilizium ausgewählten Material besteht.

17. Verfahren nach einem der Ansprüche 14-16, wobei die Widerstandsregion (11) aus einem gleichen Material besteht wie das Heizungselement.

18. Verfahren nach einem der Ansprüche 14 bis 17, wobei die Widerstandregion (11) aus einem aus TiN, TiAlN, TiSiN ausgewählten Material besteht.

19. Verfahren nach einem der Ansprüche 14 bis 18, wobei die Widerstandsregion (11) eine Dicke von weniger als 10 nm hat, vorzugsweise umfassend zwischen 1 und 10 nm, am besten 4-5 nm.

20. Verfahren nach einem der Ansprüche 14 bis 19, wobei das Bilden des Heizungselements (2) das Bilden der Isolierschicht (6; 46, 48); das Bilden einer Öffnung in der Isolierschicht; das Abscheiden einer Heizungsschicht (2) in der Öffnung; das Entfernen einer überschüssigen Heizungsschicht außerhalb der Öffnung, um eine geebnete Oberfläche zu haben, das Abscheiden eines eine Widerstandsschicht (11) und eine Chalkogenschicht (3) enthaltenden Schichtstapels (49), das Strukturieren des Schichtenstapels in einem gleichen Strukturierungsschritt, um einen die Speicherregion (3) und die Widertandsregion (11) enthaltenden Speicherstapel (49) zu bilden, umfasst.

21. Verfahren nach einem der Ansprüche 14 bis 20, wobei das Bilden des Heizungselements (2) das Bilden der Isolierschicht (46); das Bilden einer Öffnung in der Isolierschicht; das Abscheiden einer Heizungsschicht (2) in der Öffnung; das Entfernen einer überschüssigen Heizungsschicht außerhalb der Öffnung, um eine geebnete Oberfläche zu haben, das Abscheiden einer Formschicht (61) über der geebneten Oberfläche; das Bilden, in der Formschicht, einer verjüngten Öffnung (62) mit einem flacheren Boden in Kontakt mit dem Heizungselement; das Abscheiden eines eine Widerstandsschicht (11) und eine Chalkogenschicht (3) enthaltenden Schichtstapels (49), das Strukturieren des Schichtstapels (49) in einem gleichen Strukturierungsschritt, um einen die Speicherregion (3) und die Widerstandsregion (11) enthaltenden Speicherstapel mit mindestens einem Abschnitt in der verjüngten Öffnung zu bilden, umfasst.

## Revendications

1. Dispositif de mémoire à changement de phase comprenant un élément chauffant (2) et une région de mémoire (3) de matériau chalcogénique, la région de mémoire ayant une partie à changement de phase (5) en contact électrique et thermique avec ledit élément chauffant et formant un premier trajet de courant entre l'élément chauffant et une partie de repos (4) dudit élément de mémoire, la partie à changement de phase ayant une dimension et une résistivité différente de celle de la partie de repos, ladite dimension étant corrélée aux informations mémorisées dans ladite région de mémoire,
**caractérisé par** un trajet de courant parallèle (11) entre ledit élément chauffant (2) et ladite partie de repos (4) dudit élément de mémoire (3).

2. Dispositif de mémoire à changement de phase selon la revendication 1, dans lequel ledit trajet de courant parallèle (11) a une résistance qui dépend de ladite dimension et inférieure à celle de la partie à changement de phase (5).

3. Dispositif de mémoire à changement de phase selon la revendication 1 ou 2, dans lequel ledit trajet parallèle est une région résistive (11) qui s'étend depuis un bord supérieur dudit élément chauffant (2), entre une région isolante (6 ; 46, 48 ; 61) et ladite région de mémoire (3).

4. Dispositif de mémoire à changement de phase selon la revendication 3, dans lequel la région résistive (11) est en un matériau sélectionné entre le métal et le polysilicium.

5. Dispositif de mémoire à changement de phase selon la revendication 3 ou 4, dans lequel la région résistive (11) est en le même matériau que celui de l'élément chauffant.

6. Dispositif de mémoire à changement de phase selon la revendication 3 ou 4, dans lequel la région résistive (11) est en un matériau différent de celui de l'élément chauffant (2).

7. Dispositif de mémoire à changement de phase selon l'une quelconque des revendications 3 à 6, dans lequel la région résistive (11) est en un matériau sélectionné parmi TiN, TiAlN, TiSiN.

8. Dispositif de mémoire à changement de phase selon l'une quelconque des revendications 3 à 6, dans lequel la région résistive (11) a une épaisseur inférieure à 10 nm, comprise de préférence entre 1 et 10 nm, idéalement de 4 à 5 nm.

9. Dispositif de mémoire à changement de phase selon l'une quelconque des revendications 3 à 5 ou 7, 8, dans lequel la région résistive (11) est une partie saillante de l'élément chauffant (2) en contact avec la région de mémoire (3).

10. Dispositif de mémoire à changement de phase selon l'une quelconque des revendications 3 à 7, dans lequel l'élément chauffant (2) est un élément de lance entouré de ladite couche isolante (46, 48) et le dispositif comprend une pile de mémoire plane (49) comportant ladite région résistive (11) et ladite région de mémoire (3).

11. Dispositif de mémoire à changement de phase selon l'une quelconque des revendications 3 à 7, dans lequel la région isolante comprend une couche diélectrique (46) qui entoure l'élément chauffant (2) et une couche de moule (61) qui s'étend par dessus la couche diélectrique, la couche de moule ayant une micro-tranchée conique (62) ayant une base plus profonde vers l'élément chauffant (2) et une pile de mémoire (49) qui s'étend au moins en partie dans ladite micro-tranchée conique et comporte ladite région résistive (11) et ladite région de mémoire (3).

12. Système comprenant :
un processeur (510) ;
une mémoire vive statique (560) couplée audit processeur ; et
une mémoire (530) couplée audit processeur, la mémoire comprenant le dispositif de mémoire à changement de phase (10) selon l'une quelconque des revendications 1 à 11.

13. Processus de fabrication d'un dispositif de mémoire à changement de phase comprenant la formation d'un élément chauffant (2) et la formation d'une région de mémoire (3) d'un matériau chalcogénique en contact électrique et thermique avec l'élément chauffant, la région de mémoire ayant une partie à changement de phase (5) vers l'élément chauffant formant un premier trajet de courant entre l'élément chauffant et une partie de repos (4) dudit élément de mémoire, la partie à changement de phase ayant une dimension et une résistivité différente de celle d'une partie de repos, ladite dimension étant corrélée à des informations mémorisées dans ladite région de mémoire,
**caractérisé par** la formation d'un trajet de courant parallèle (11) entre ledit élément chauffant (2) et ladite partie de repos (4) dudit élément de mémoire.

14. Processus selon la revendication 13, dans lequel la formation d'un trajet de courant parallèle comprend, avant la formation de ladite région de mémoire, la formation d'une région résistive (11) sur une région isolante (6 ; 46, 48) entourant l'élément chauffant (2) et s'étendant depuis un bord supérieur dudit élément chauffant.

15. Processus selon la revendication 14, dans lequel la partie à changement de phase (5) a une résistivité supérieure à celle de ladite partie de repos (4) et la région résistive (11) a une résistivité inférieure à celle de la partie à changement de phase (5).

16. Processus selon la revendication 14 ou 15, dans lequel la région résistive (11) est en un matériau sélectionné entre le métal et le polysilicium.

17. Processus selon l'une quelconque des revendications 14 à 16, dans lequel la région résistive (11) est en le même matériau que celui de l'élément chauffant.

18. Processus selon l'une quelconque des revendications 14 à 17, dans lequel la région résistive (11) est en un matériau sélectionné parmi TiN, TiAIN, TiSiN.

19. Processus selon l'une quelconque des revendications 14 à 18, dans lequel la région résistive (11) a une épaisseur inférieure à 10 nm, comprise de préférence entre 1 et 10 nm, idéalement de 4 à 5 nm.

20. Processus selon l'une quelconque des revendications 14 à 19, dans lequel la formation de l'élément chauffant (2) comprend la formation de la couche isolante (6 ; 46, 48) ; la formation d'une ouverture dans la couche isolante ; le dépôt d'une couche chauffante (2) dans l'ouverture ; le retrait d'une couche chauffante excédentaire en dehors de l'ouverture pour avoir une surface planarisée ; le dépôt d'une pile de couches (49) comportant une couche résistive (11) et une couche chalcogénique (3) ; l'application d'un motif sur la pile de couches durant une même étape d'application de motif afin de former une pile de mémoire (49) comportant la région de mémoire (3) et la région résistive (11).

21. Processus selon l'une quelconque des revendications 14 à 20, dans lequel la formation de l'élément chauffant (2) comprend la formation de la couche isolante (46) ; la formation d'une ouverture dans la couche isolante ; le dépôt d'une couche chauffante (2) dans l'ouverture ; le retrait d'une couche chauffante excédentaire en dehors de l'ouverture pour avoir une surface planarisée ; le dépôt d'une couche de moule (61) par dessus la surface planarisée ; la formation, dans la couche de moule, d'une ouverture conique (62) ayant une base plus profonde en contact avec l'élément chauffant ; le dépôt d'une pile de couches (49) comportant une couche résistive (11) et une couche chalcogénique (3) ; l'application d'un motif sur la pile de couches (49) durant une même étape d'application de motif afin de former une pile de mémoire comportant la région de mémoire (3) et la région résistive (11) ayant au moins une partie dans l'ouverture conique.
